# EUROPEAN PATENT APPLICATION

(11) **EP 4 636 412 A1**
(43) Date of publication of application: **22.10.2025**
(21) Application number: 25169632.4
(22) Date of filing: 10.04.2025
(51) Int. Cl.: G01R 27/02, H01M 10/00, G01R 31/389

(54) **APPARATUS FOR INSPECTING INSULATION OF SEPARATOR FOR SECONDARY BATTERIES**

(30) Priority: 15.04.2024 KR 20240049778
(71) Applicant: SAMSUNG SDI CO., LTD., Yongin-si, Gyeonggi-do 17084 (KR)
(72) Inventor: SHIN, Eui Chol, 17084 Gyeonggi-do (KR)
(74) Representative: Michalski Hüttermann & Partner Patentanwälte mbB

(57) **Abstract**

Disclosed is an apparatus for inspecting the insulation of a separator for batteries capable of inspecting the insulation of a separator in real time by applying current or voltage after pressing an upper metallic member and a lower metallic member toward each other. The apparatus includes an upper metallic member, a lower metallic member under the upper metallic member, and configured to press the separator with the upper metallic member, and a source meter electrically connected to the upper metallic member and to the lower metallic member, and configured to apply a voltage and/or current between the upper metallic member and the lower metallic member, and to measure resistance and/or current between the upper metallic member and the lower metallic member corresponding to the insulation of the separator.

## Description

### BACKGROUND

### 1. Field

Embodiments of the present disclosure relate to an apparatus for inspecting the insulation of a separator for secondary batteries.

### 2. Description of the Related Art

A secondary battery is a power storage system that converts electrical energy into chemical energy, that stores the chemical energy, and that provides high energy density. Compared to a primary battery, which is not rechargeable, a secondary battery is rechargeable, and is widely used in IT devices, such as a smartphone, a cellular phone, a laptop computer, and a tablet computer. Recently, there has been an increased interest in electric vehicles to reduce or prevent environmental pollution, and a high-capacity secondary battery is being adopted in electric vehicles. The secondary battery has characteristics, such as high density, high output, and stability.

The information disclosed in this section is provided only for enhancement of understanding of the background of the present disclosure, and therefore it may contain information that does not form the prior art.

### SUMMARY

Embodiments of the present disclosure provide an apparatus for inspecting the insulation of a separator for secondary batteries capable of inspecting the insulation of a separator for secondary batteries in real time by applying current or voltage after pressing an upper metallic member and a lower metallic member toward each other.

It should be noted that aspects of the present disclosure are not limited to the aspects mentioned above, and other unmentioned aspects of the present disclosure will be clearly understood by those skilled in the art from the following description.

An apparatus for inspecting the insulation of a separator for a battery according to one or more embodiments of the present disclosure includes an upper metallic member, a lower metallic member under the upper metallic member, and configured to press the separator with the upper metallic member, and a source meter electrically connected to the upper metallic member and to the lower metallic member, and configured to apply a voltage and/or current between the upper metallic member and the lower metallic member, and to measure resistance and/or current between the upper metallic member and the lower metallic member corresponding to the insulation of the separator.

A shape of the upper metallic member and the lower metallic member may be a column extending in a first direction.

The apparatus may further include an upper fixed shaft extending through a central axis of the upper metallic member, and a lower fixed shaft extending through a central axis of the lower metallic member, wherein the source meter contacts, and is electrically connected to, the upper fixed shaft and the lower fixed shaft.

The apparatus may further include an upper metal ball bearing between the upper fixed shaft and the upper metallic member, and a lower metal ball bearing between the lower metallic member and the lower fixed shaft.

The upper metal ball bearing and the lower metal ball bearing may include a conductor.

The upper metallic member may be rotatable about the upper fixed shaft, wherein the lower metallic member is rotatable about the lower fixed shaft, and wherein the source meter contacts, and is electrically connected to, the upper fixed shaft and the lower fixed shaft.

The apparatus may further include an upper insulating cover covering an upper end of the upper metallic member, and spaced apart from the lower metallic member, and a lower insulating cover covering a lower end of the lower metallic member, and spaced apart from the lower metallic member.

The upper insulating cover and the lower insulating cover may be epoxidized and electrically connected to a ground wire of the source meter.

The apparatus may further include an upper pressing frame configured to press the upper fixed shaft downwardly from above, and a lower pressing frame configured to press the lower fixed shaft upwardly from below.

The apparatus may further include an upper resilient member between the upper pressing frame and the upper fixed shaft, and a lower resilient member between the lower pressing frame and the lower fixed shaft.

The upper pressing frame and the lower pressing frame may be configured to press the separator between the upper metallic member and the lower metallic member.

The upper metallic member may include a plurality of upper metallic members spaced apart in a third direction substantially perpendicular to the first direction, wherein the lower metallic member includes a plurality of lower metallic members under the upper metallic members to be spaced apart therefrom in an upward-downward direction that is substantially perpendicular to the first direction and to the third direction.

Each of the upper metallic member and the lower metallic member may have a shape of a rectangular plate.

The apparatus may further include an upper insulating cover covering an outside of the upper metallic member, and spaced apart from the upper metallic member, and a lower insulating cover covering an outside of the lower metallic member, and spaced from the lower metallic member.

The upper insulating cover may cover an upper surface and a side wall of the upper metallic member, and may expose a lower surface of the upper metallic member in a direction toward the lower metallic member, wherein the lower insulating cover covers a lower surface and a side wall of the lower metallic member, and exposes an upper surface of the lower metallic member in a direction toward the upper metallic member.

A lower surface of the upper metallic member may face an upper surface of the lower metallic member.

The upper metallic member may further include an upper protrusion protruding and extending from opposite side walls thereof in the first direction, wherein the lower metallic member further includes a lower protrusion protruding and extending from opposite side walls thereof in the first direction.

The source meter may contact, and may be electrically connected to, the upper protrusion and the lower protrusion.

The apparatus may further include an upper pressing frame configured to press the upper protrusion downwardly from above, a lower pressing frame configured to press the lower protrusion upwardly from below, an upper resilient member between the upper pressing frame and the upper protrusion, and a lower resilient member between the lower pressing frame and the lower protrusion.

The upper metallic member may have a bar shape extending in the first direction, and may include a plurality of upper metallic members spaced apart from each other in a third direction substantially perpendicular to the first direction, wherein the lower metallic member has a bar shape extending in the first direction, includes a plurality of lower metallic members under the upper metallic members and spaced apart therefrom in an upward-downward direction that is substantially perpendicular to the first direction and to the third direction.

### BRIEF DESCRIPTION OF THE DRAWINGS

The accompanying drawings, which are incorporated in this specification, illustrate embodiments and serve to further illustrate the technical ideas of the present disclosure in conjunction with the detailed description of embodiments that follows, and the present disclosure is not to be construed as limited to what is shown in such drawings. In the drawings:
FIG. 1 is a longitudinal sectional view showing an apparatus for inspecting the insulation of a separator for secondary batteries according to one or more embodiments of the present disclosure;
FIG. 2 is a cross-sectional view taken along the line A-A' of FIG. 1;
FIG. 3 is a side view of FIG. 1;
FIG. 4 is a cross-sectional view showing an apparatus for inspecting the insulation of a separator for secondary batteries according to one or more other embodiments of the present disclosure;
FIG. 5 is a longitudinal view showing an apparatus for inspecting the insulation of a separator for secondary batteries according to one or more other embodiments of the present disclosure;
FIG. 6 is a cross-sectional view taken along the line B-B' of FIG. 5;
FIG. 7 is a cross-sectional view showing an apparatus for inspecting the insulation of a separator for secondary batteries according to one or more further embodiments of the present disclosure; and
FIG. 8 is a view showing the results of inspection of the insulation of various separators inspected using the apparatus for inspecting the insulation of the separator for secondary batteries according to the present disclosure.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that the present disclosure covers all modifications, equivalents, and replacements within the idea and technical scope of the present disclosure, that each of the features of embodiments of the present disclosure may be combined with each other, in part or in whole, and technically various interlocking and operating are possible, and that each embodiment may be implemented independently of each other, or may be implemented together in an association, unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. Additionally, the use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified.

Various embodiments are described herein with reference to sectional illustrations that are schematic illustrations of embodiments and/or intermediate structures. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

Spatially relative terms, such as "beneath," "below," "lower," "lower side," "under," "above," "upper," "over," "higher," "upper side," "side" (e.g., as in "sidewall"), and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below," "beneath," "or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. Similarly, when a first part is described as being arranged "on" a second part, this indicates that the first part is arranged at an upper side or a lower side of the second part without the limitation to the upper side thereof on the basis of the gravity direction.

Further, the phrase "in a schematic cross-sectional view" means when a schematic cross-section taken by vertically cutting an object portion is viewed from the side. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component is referred to as being "formed on," "on," "connected to," or "(operatively or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection. For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a resistor, a capacitor, and/or the like. In describing embodiments, an expression of connection indicates electrical connection unless explicitly described to be direct connection, and "directly connected/directly coupled," or "directly on," refers to one component directly connecting or coupling another component, or being on another component, without an intermediate component.

In addition, in the present specification, when a portion of a layer, a film, an area, a plate, or the like is formed on another portion, a forming direction is not limited to an upper direction but includes forming the portion on a side surface or in a lower direction. On the contrary, when a portion of a layer, a film, an area, a plate, or the like is formed "under" another portion, this includes not only a case where the portion is "directly beneath" another portion but also a case where there is further another portion between the portion and another portion. Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XYY, YZ, and ZZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are used only used to distinguish one element, member, component, region, area, layer, section, or portion from another element, member, component, region, area, layer, section, or portion. Thus, a first element, component, region, layer or section described below could be termed a second element, component, region, layer or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be substantially perpendicular to one another, or may represent different directions that are not substantially perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

When one or more embodiments may be implemented differently, a specific process order may be performed differently from the described order. For example, two consecutively described processes may be performed substantially at the same time or performed in an order opposite to the described order.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure."

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

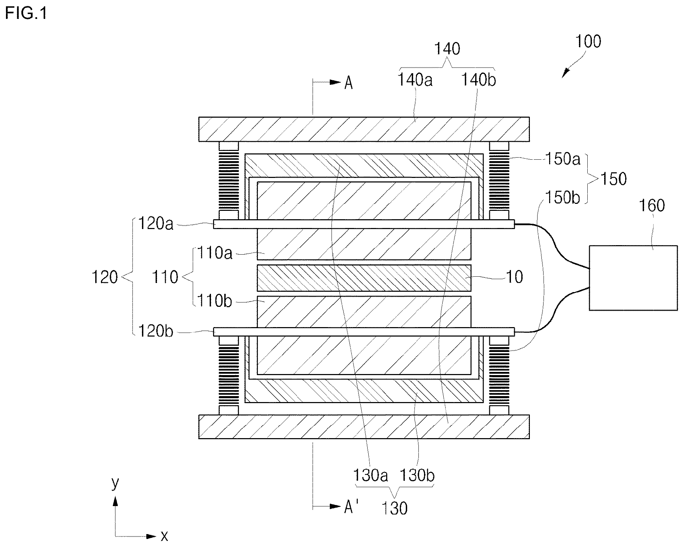

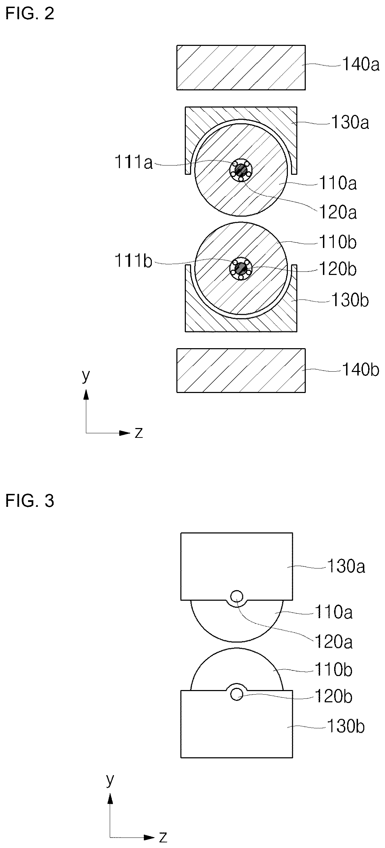

FIG. 1 is a longitudinal sectional view showing an apparatus for inspecting the insulation of a separator for secondary batteries according to one or more embodiments of the present disclosure. FIG. 2 is a cross-sectional view taken along the line A-A' of FIG. 1. FIG. 3 is a side view of FIG. 1.

Referring to FIGS. 1, 2, and 3, the insulation inspection apparatus 100 for inspecting the insulation of the separator for secondary batteries may include a pair of metallic members 110 located above and below so as to be opposite each other, a fixed shaft 120 extending through the center of the pair of metallic members 110, an insulating cover 130 configured to cover an outer surface of the pair of metallic members 110, a pressing frame 140 configured to press the pair of metallic members 110 toward each other, a resilient member 150 interposed between the fixed shaft 120 and the pressing frame 140, and a source meter 160 electrically connected to the fixed shaft 120.

The metallic members 110 may include an upper metallic member 110a located above, and a lower metallic member 110b located below. Each of the upper metallic member 110a and the lower metallic member 110b may be formed in the shape of a column extending in a first direction x. The central axis of the upper metallic member 110a and the central axis of the lower metallic member 110b may be substantially parallel to each other. The upper metallic member 110a and the lower metallic member 110b may extend in the first direction x. The upper metallic member 110a and the lower metallic member 110b may be spaced apart from each other. A separator 10 for secondary batteries may be located between the upper metallic member 110a and lower metallic member 110b spaced apart from each other. The separator 10 for secondary batteries may be interposed between an outer surface of the upper metallic member 110a and an outer surface of the lower metallic member 110b. The separator 10 for secondary batteries may be an insulator or a solid electrolyte of an all-solid-state battery. Hereinafter, the expression "separator 10 for secondary batteries" will be used for convenience of description.

The fixed shaft 120 may include an upper fixed shaft 120a extending through the central axis of the upper metallic member 110a, and a lower fixed shaft 120b extending through the central axis of the lower metallic member 110b. Each of the upper fixed shaft 120a and the lower fixed shaft 120b may have a circular bar shape. in one or more embodiments, each of the upper fixed shaft 120a and the lower fixed shaft 120b may have a larger length in the first direction x than the metallic member 110. A central region of the upper fixed shaft 120a may be enclosed by the upper metallic member 110a, and opposite ends of the upper fixed shaft 120a may be exposed to the outside. A central region of the lower fixed shaft 120b may be enclosed by the lower metallic member 110b, and opposite ends of the lower fixed shaft 120b may be exposed to the outside.

Each of the upper fixed shaft 120a and the lower fixed shaft 120b may be made of a metal having relatively high electrical conductivity. An upper metal ball bearing 111a may be interposed between the upper fixed shaft 120a and the upper metallic member 110a. The upper metal ball bearing 111a may be made of a conductor. The upper metal ball bearing 111a may allow the upper metallic member 110a to rotate outside the upper fixed shaft 120a. The upper metal ball bearing 111a may transmit voltage applied from the source meter 160 to the upper fixed shaft 120a to the upper metallic member 110a.

The lower fixed shaft 120b may be made of a metal with relatively high electrical conductivity. A lower metal ball bearing 111b may be interposed between the lower fixed shaft 120b and the lower metallic member 110b. The lower metal ball bearing 111b may be made of a conductor. The lower metal ball bearing 111b may allow the lower metallic member 110b to rotate outside the lower fixed shaft 120b. The lower metal ball bearing 111b may transmit a voltage applied from the source meter 160 to the lower fixed shaft 120b to the lower metallic member 110b.

The source meter 160 may be in contact with, and may be electrically connected to, the upper fixed shaft 120a and the lower fixed shaft 120b to apply voltage and/or current between opposite ends thereof. The source meter 160 may measure resistance and/or current between the upper fixed shaft 120a and the lower fixed shaft 120b in real time.

The insulating cover 130 may include an upper insulating cover 130a configured to cover an upper end of the upper metallic member 110a, and a lower insulating cover 130b configured to cover a lower end of the lower metallic member 110b. The upper insulating cover 130a may be spaced apart from the outer surface of the upper metallic member 110a. The upper insulating cover 130a may be an epoxidized cover. The upper insulating cover 130a may be electrically connected to a ground wire such that damage to the upper insulating cover due to static electricity on the upper metallic member 110a is reduced or prevented. For example, the upper insulating cover 130a may be electrically connected to a ground wire of the source meter 160. Opposite ends of the upper insulating cover 130a in the first direction x may be fixed to the upper fixed shaft 120a. In one or more embodiments, an insulator may be further interposed between the upper insulating cover 130a and the upper fixed shaft 120a. In one or more embodiments, the insulator may reduce or prevent the likelihood of current and/or voltage from the upper fixed shaft 120a being transmitted to the upper insulating cover 130a.

The lower insulating cover 130b may be spaced apart from the outer surface of the lower metallic member 110b, and opposite ends of the lower insulating cover 130b in the first direction x may be fixed to the lower fixed shaft 120b. In one or more embodiments, an insulator may be further interposed between the lower insulating cover 130b and the lower fixed shaft 120b. The lower insulating cover 130b may be an epoxidized cover, and may be electrically connected to the ground wire of the source meter 160.

Although the outer shape of each of the upper insulating cover 130a and the lower insulating cover 130b is shown as being approximately cuboidal in shape, various variations are possible, and the present disclosure is not limited thereto. The insulating cover 130 may cover the outside of the electrically charged metallic member 110, which may improve safety.

The pressing frame 140 may include an upper pressing frame 140a configured to press the upper metallic member 110a downward, and a lower pressing frame 140b configured to press the lower metallic member 110b upward. Each of the upper pressing frame 140a and the lower pressing frame 140b may be approximately flat. The upper pressing frame 140a may be located above the upper metallic member 110a, and the lower pressing frame 140b may be located under the lower metallic member 110b.

The upper pressing frame 140a may be coupled to the upper fixed shaft 120a via an upper resilient member 150a of the resilient member 150. For example, opposite sides of the upper pressing frame 140a may be coupled respectively to opposite ends of the upper fixed shaft 120a via the upper resilient member 150a. The lower pressing frame 140b may be coupled to the lower fixed shaft 120b via a lower resilient member 150b of the resilient member 150. For example, opposite sides of the lower pressing frame 140b may be coupled respectively to opposite ends of the lower fixed shaft 120b via the lower resilient member 150b. The upper pressing frame 140a may apply pressure to the upper fixed shaft 120a via the upper resilient member 150a, and the lower pressing frame 140b may apply pressure to the lower fixed shaft 120b via the lower resilient member 150b.

The pressing frame 140 and the resilient member 150 may ensure that the separator 10 for secondary batteries is consistently pressed at a pressure (e.g., predetermined pressure) even if the thickness of the separator 10 for secondary batteries interposed between the upper metallic member 110a and the lower metallic member 110b is changed. For example, if the thickness of the separator 10 introduced between the upper metallic member 110a and the lower metallic member 110b is increased, the upper resilient member 150a, interposed between the upper fixed shaft 120a and the upper pressing frame 140a, and the lower resilient member 150b, interposed between the lower fixed shaft 120b and the lower pressing frame 140b, may be further compressed, whereby the separator interposed between the upper metallic member 110a and the lower metallic member 110b may be consistently pressed at the pressure (e.g., predetermined pressure). The pressure (e.g., predetermined pressure) may be greater than or equal to about 0.1 MPa. If the separator 10 for secondary batteries is pressed at a pressure that is less than about 0.1 MPa, the separator may be measured to be insulated even if debris or pinholes are present in the separator, and a pressure equal to or greater than about 0.1 MPa may be suitable for insulation inspection.

The resilient member 150 may be a variable spring. A pressure sensor may be further interposed between the pressing frame 140 and the resilient member 150. The pressure information measured by the pressure sensor may be used to maintain a constant pressure between the resilient member 150 and the pressing frame 140.

The resilient member 150 and the pressing frame 140 may be controlled such that the pressure (e.g., predetermined pressure) is applied to the separator 10 for secondary batteries interposed between the upper metallic member 110a and the lower metallic member 110b depending on the type of the separator 10 for secondary batteries.

An insulator may be further interposed between the upper resilient member 150a and the upper fixed shaft 120a, and between the lower resilient member 150b and the lower fixed shaft 120b. The insulator may reduce or prevent the likelihood of current and/or voltage, which is applied to the upper fixed shaft 120a and the lower fixed shaft 120b, being transmitted to the pressing frame 140 via the resilient member 150.

The source meter 160 may apply voltage and/or current between the upper fixed shaft 120a and the lower fixed shaft 120b. The upper fixed shaft 120a may be electrically and mechanically connected to the upper metallic member 110a via the upper metal ball bearing 111a. The upper metallic member 110a may be rotatable about the upper fixed shaft 120a. The lower metallic member 110b may be rotatable about the lower fixed shaft 120b.

Because the separator 10 for secondary batteries is located between the upper metallic member 110a and the lower metallic member 110b, and because the upper metallic member 110a and the lower metallic member 110b are rotatable, the separator 10 for secondary batteries may be moved between the upper metallic member 110a and the lower metallic member 110b. A substantially uniform pressure may be applied between the upper metallic member 110a and the lower metallic member 110b.

The source meter 160 may be electrically connected to the upper metallic member 110a via the upper fixed shaft 120a, and may be electrically connected to the lower metallic member 110b via the lower fixed shaft 120b. The separator 10 for secondary batteries may be in contact with the surface of the upper metallic member 110a and the surface of the lower metallic member 110b.

The separator 10 for the secondary battery interposed between the upper metallic member 110a and the lower metallic member 110b may be continuously movable by rotation of the metallic member 110. The source meter 160 may apply voltage and/or current to the upper metallic member 110a and the lower metallic member 110b, and may measure and record resistance and/or current while the separator (insulator) is moved between the upper metallic member 110a and the lower metallic member 110b. As such, voltage and/or current may be applied between the upper metallic member 110a and the lower metallic member 110b through the source meter 160, and the insulation of the separator 10 for secondary batteries interposed between the upper metallic member 110a and the lower metallic member 110b may be inspected in real time.

For example, if debris or pinholes are present in the separator interposed between the upper metallic member 110a and the lower metallic member 110b, and are pressed at the pressure (e.g., predetermined pressure), the measured current and/or resistance may be reduced due to leakage current in the region where the debris or the pinholes are located. In one or more embodiments of the present disclosure, one upper metallic member 110a and one lower metallic member 110b may be provided.

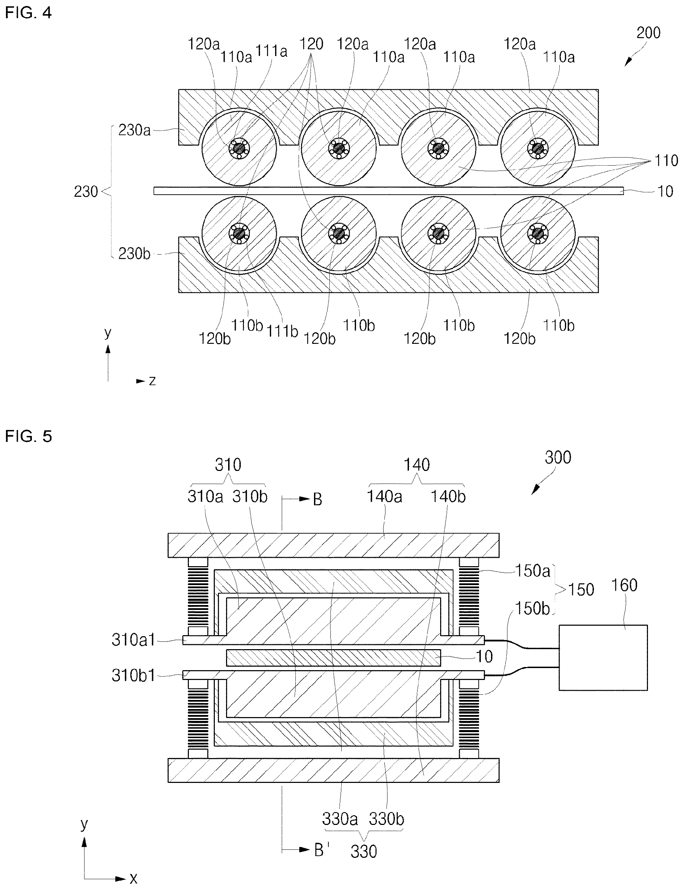

Referring to FIG. 4, a plurality of upper metallic members 110a and a plurality of lower metallic members 110b may be spaced apart from each other such that fixed shafts 120 thereof are substantially parallel to each other. An insulation inspection apparatus 200 for inspecting the insulation of a separator for secondary batteries may include a plurality of upper metallic members 110a and a plurality of lower metallic members 110b. The plurality of upper metallic members 110a and the plurality of lower metallic members 110b may be located so as to correspond to each other. Each of the upper metallic members 110a may be located above a corresponding one of the lower metallic members 110b. The plurality of upper metallic members 110a and lower metallic members 110b may have the same diameter. Constant pressure or different pressures may be applied to a separator 10 for secondary batteries interposed between the plurality of upper metallic members 110a and the plurality of lower metallic members 110b.

An upper fixed shaft 120a may be located at the central axis of each of the upper metallic members 110a, and a lower fixed shaft 120b may be located at the central axis of each of the lower metallic members 110b. The relationship between the upper metallic member 110a and the upper fixed shaft 120a may be the same as in the insulation inspection apparatus 100 for inspecting the insulation of the separator for secondary batteries shown in FIGS. 1, 2, and 3. The relationship between the lower metallic member 110b and the lower fixed shaft 120b may also be the same as in the insulation inspection apparatus 100 for inspecting the insulation of the separator for secondary batteries shown in FIGS. 1, 2, and 3.

Each of the upper fixed shafts 120a and each of the lower fixed shafts 120b may be electrically connected to a source meter 160. Each of the upper fixed shafts 120a may be electrically connected to a corresponding one of the upper metallic members 110a, and each of the lower fixed shafts 120b may be electrically connected to a corresponding one of the lower metallic members 110b.

Each of the plurality of upper fixed shafts 120a may be coupled to an upper pressing frame 140a via a corresponding one of a plurality of upper resilient members 150a. The upper pressing frame 140a may be located above the plurality of upper metallic members 110a. The upper pressing frame 140a may press the plurality of upper metallic members 110a downwardly via the plurality of upper resilient members 150a. Each of the plurality of upper metallic members 110a may be coupled to a corresponding one of the plurality of upper fixed shafts 120a. The resilient member 150 and the pressing frame 140 may be respectively similar in structure and operation to the resilient member 150 and the pressing frame 140 of the insulation inspection apparatus 100 for inspecting the insulation of the separator for secondary batteries shown in FIGS. 1 and 2.

In the insulation inspection apparatus 200 for inspecting the insulation of the separator for secondary batteries, an upper insulating cover 230a may cover upper ends of the plurality of upper metallic members 110a, and a lower insulating cover 230b may cover lower ends of the plurality of lower metallic members 110b.

If the insulation inspection apparatus 200 for inspecting the insulation of the separator for secondary batteries includes a plurality of metallic members 110, accuracy in inspection of the insulation of the separator (insulator) may be further increased.

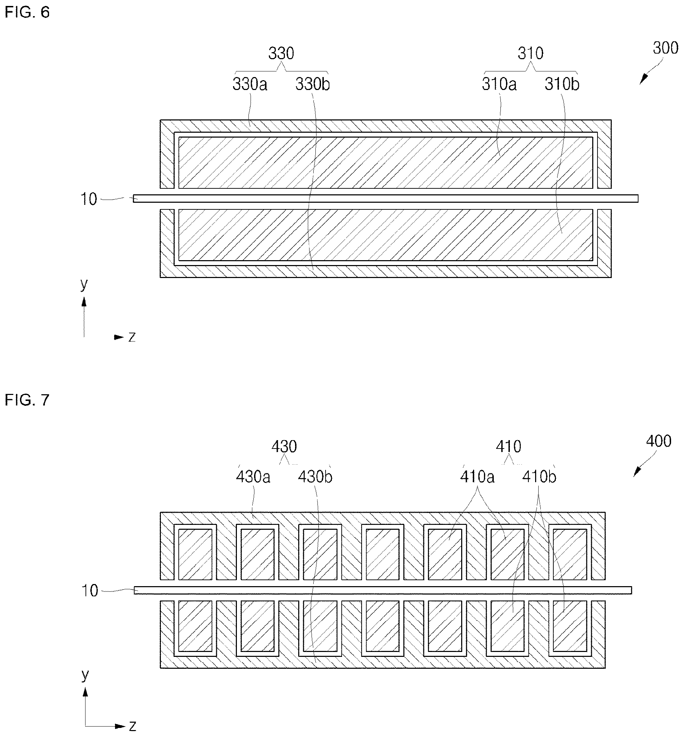

FIG. 5 is a longitudinal view showing an apparatus for inspecting the insulation of a separator for secondary batteries according to one or more other embodiments of the present disclosure, and FIG. 6 is a cross-sectional view of the apparatus for inspecting the insulation of the separator for secondary batteries taken along the line B-B' of FIG. 5.

Referring to FIGS. 5 and 6, the insulation inspection apparatus 300 for inspecting the insulation of the separator for secondary batteries may include a pair of metallic members 310 located above and below so as to be opposite each other, an insulating cover 330 configured to cover an outer surface of the pair of metallic members 310, a pressing frame 140 configured to press the pair of metallic members 310 toward each other, a resilient member 150 interposed between each of the metallic members 310 and the pressing frame 140, and a source meter 160 electrically connected to the metallic members 310. The configuration of the insulation inspection apparatus 300 may be similar to the configuration of the insulation inspection apparatus 100 shown in FIG. 1. For example, the pressing frame 140, the resilient member 150, and the source meter 160 of the insulation inspection apparatus 300 may be respectively similar to the pressing frame 140, the resilient member 150, and the source meter 160 of the insulation inspection apparatus 100. Hereinafter, the insulation inspection apparatus 300 will be described based on the metallic members 310 and the insulating cover 330, which are different in configuration from the metallic members 110 and the insulating cover 130 of the insulation inspection apparatus 100.

The metallic members 310 may include an upper metallic member 310a located above, and a lower metallic member 310b located below. Each of the upper metallic member 310a and the lower metallic member 310b may be formed in the shape of a flat rectangular plate. The upper metallic member 310a and the lower metallic member 310b may be substantially parallel to each other. Each of the upper metallic member 310a and the lower metallic member 310b may be made of a metal having relatively high electrical conductivity.

The upper metallic member 310a and the lower metallic member 310b may extend in the first direction x. The upper metallic member 310a and the lower metallic member 310b may be spaced apart from each other. A separator 10 for secondary batteries may be located between the upper metallic member 310a and lower metallic member 310b spaced apart from each other. The separator 10 for secondary batteries may be interposed between an outer surface of the upper metallic member 310a and an outer surface of the lower metallic member 310b.

The upper metallic member 310a may further include an upper protrusion 310a1 respectively protruding from each of opposite side walls thereof in the first direction x, and the lower metallic member 310b may further include a lower protrusion 310b1 respectively protruding from each of opposite side walls thereof in the first direction x. The upper protrusions 310a1 may protrude from the opposite side walls of the upper metallic member 310a in the first direction x, and may be on the same line in the first direction x. The lower protrusions 310b1 may protrude from the opposite side walls of the lower metallic member 310b in the first direction x, and may be on the same line in the first direction x. The upper protrusion 310a1 and the lower protrusion 310b1 may be substantially parallel to each other. In FIG. 5, the upper protrusion 310a1 is shown as being located under the side wall of the upper metallic member 310a, but the upper protrusion 310a1 may be located above the side wall of the upper metallic member 310a, and the position of the upper protrusion 310a1 may be variously changed. The lower protrusion 310b1 is shown as being located above the side wall of the lower metallic member 310b, but the lower protrusion 310b1 may be located under the side wall of the lower metallic member 310b, and the position of the lower protrusion 310b1 may be variously changed.

The upper protrusion 310a1 of the upper metallic member 310a and the lower protrusion 310b1 of the lower metallic member 310b may be in contact with, and may be electrically connected to, the source meter 160, which may apply voltage and/or current between opposite ends thereof.

The source meter 160 may measure resistance and/or current between the upper metallic member 310a and the lower metallic member 310b in real time.

The insulating cover 330 may include an upper insulating cover 330a configured to cover an outer surface of the upper metallic member 310a and a lower insulating cover 330b configured to cover an outer surface of the lower metallic member 310b. The upper insulating cover 330a may cover an upper surface and a side wall of the upper metallic member 310a, and may expose a lower surface of the upper metallic member 310a in a direction toward the lower metallic member 310b. The lower insulating cover 330b may cover a lower surface and a side wall of the lower metallic member 310b, and may expose an upper surface of the lower metallic member 310b in a direction toward the upper metallic member 310a. The lower surface of the upper metallic member 310a and the upper surface of the lower metallic member 310b may face each other.

The upper insulating cover 330a may be spaced apart from the outer surface of the upper metallic member 310a. The upper insulating cover 330a may be an epoxidized cover. The upper insulating cover 330a may be electrically connected to a ground wire such that damage to the upper insulating cover due to static electricity on the upper metallic member 110a is reduced or prevented. For example, the upper insulating cover 330a may be electrically connected to a ground wire of the source meter 160. Opposite ends of the upper insulating cover 330a in the first direction x may be fixed respectively to the upper protrusions 310a1 of the upper metallic member 310a. In one or more embodiments, an insulator may be further interposed between the upper insulating cover 330a and the upper protrusion 310a1. In one or more embodiments, the insulator may reduce or prevent the likelihood of current and/or voltage from the upper protrusion 310a1 being transmitted to the upper insulating cover 330a.

The lower end of the upper insulating cover 330a may be located higher than the upper metallic member 310a. The upper metallic member 310a may protrude farther downwardly than the lower end of the upper insulating cover 330a. This may reduce or prevent interference of the upper insulating cover 330a if the upper metallic member 310a comes into contact with the separator 10 for secondary batteries.

The lower insulating cover 330b may be spaced apart from the outer surface of the lower metallic member 310b, and opposite ends of the lower insulating cover 330b in the first direction x may be fixed respectively to the lower protrusions 310b1. In one or more embodiments, an insulator may be further interposed between the lower insulating cover 330b and the lower protrusion 310b1. The lower insulating cover 330b may be an epoxidized cover, and may be electrically connected to the ground wire of the source meter 160. The upper end of the lower insulating cover 330b may be located lower than the lower metallic member 310b. The lower metallic member 310b may protrude farther upwardly than the upper end of the lower insulating cover 330b. This may reduce or prevent interference of the lower insulating cover 330b if the lower metallic member 310b comes into contact with the separator 10 for secondary batteries.

Although the outer shape of each of the upper insulating cover 330a and the lower insulating cover 330b is shown as being approximately cuboidal, various variations are possible and the present disclosure is not limited thereto. The insulating cover 330 may cover the outside of the electrically charged metallic member 310, which may improve safety.

The pressing frame 140 may include an upper pressing frame 140a configured to press the upper metallic member 310a downwardly, and a lower pressing frame 140b configured to press the lower metallic member 310b upward. Each of the upper pressing frame 140a and the lower pressing frame 140b may be approximately flat.

The upper pressing frame 140a may be coupled to the upper protrusion 310a1 via an upper resilient member 150a of the resilient member 150. For example, opposite sides of the upper pressing frame 140a may be coupled respectively to opposite ends of the upper protrusion 310a1 via the upper resilient member 150a. The lower pressing frame 140b may be coupled to the lower protrusion 310b1 via a lower resilient member 150b of the resilient member 150. For example, opposite sides of the lower pressing frame 140b may be coupled respectively to opposite ends of the lower protrusion 310b1 via the lower resilient member 150b. The upper pressing frame 140a may apply pressure to the upper protrusion 310a1 via the upper resilient member 150a, and the lower pressing frame 140b may apply pressure to the lower protrusion 310b1 via the lower resilient member 150b. The resilient member 150 and the pressing frame 140 may be similar in structure and operation to the resilient member 150 and the pressing frame 140 of the insulation inspection apparatus 100 shown in FIGS. 1 and 2.

The separator 10 for secondary batteries may be located between the upper metallic member 310a and the lower metallic member 310b, and substantially uniform pressure may be applied to the upper metallic member 310a and the lower metallic member 310b.

The upper protrusion 310a1 of the upper metallic member 310a and the lower protrusion 310b1 of the lower metallic member 310b may be in contact with, and may be electrically connected to, the source meter 160, which may apply voltage and/or current between opposite ends thereof. The source meter 160 may measure resistance and/or current between the upper metallic member 310a and the lower metallic member 310b in real time.

The source meter 160 may be in contact with, and electrically connected to, the upper protrusion 310a1 of the upper metallic member 310a, and may be in contact with, and electrically connected to, the lower protrusion 310b1 of the lower metallic member 310b. The separator 10 for secondary batteries may be in contact with the surface of the upper metallic member 310a and the surface of the lower metallic member 310b. The source meter 160 may be similar in structure and operation to the source meter 160 of the insulation inspection apparatus 100 shown in FIGS. 1 and 2.

For example, if debris or pinholes are present in the separator 10 for secondary batteries interposed between the upper metallic member 310a and the lower metallic member 310b, and are pressed at a pressure (e.g., predetermined pressure), the measured current and/or resistance may be reduced due to leakage current in the region where the debris or the pinholes are located.

In FIGS. 5 and 6, one upper metallic member 310a and one lower metallic member 310b are shown. Referring to FIG. 7, a plurality of upper metallic member 410a and a plurality of lower metallic member 410b may be spaced apart from each other so as to be substantially parallel to each other. Each of the upper metallic members 410a and the lower metallic members 410b may have a bar shape extending in the first direction x.

An apparatus 400 for inspecting the insulation of a separator for secondary batteries may include a plurality of upper metallic members 410a and a plurality of lower metallic members 410b. The plurality of upper metallic members 410a and the plurality of lower metallic members 410b may be located so as to correspond to each other. Each of the upper metallic members 410a may be located above a corresponding one of the lower metallic members 410b. The plurality of upper metallic members 410a and lower metallic members 410b may have the same planar width. Constant pressure may be applied to a separator 10 for secondary batteries interposed between the plurality of upper metallic members 410a and the plurality of lower metallic members 410b.

A protrusion of each of the upper metallic members 410a and a protrusion of a corresponding one of the lower metallic members 410b may be electrically connected to the source meter 160. At this time, respective ones of the upper metallic members 410a and respective ones of the lower metallic members 410b electrically connected to the source meter 160 may be located on the same line in a second direction y, which is an upward-downward direction. The protrusions of the plurality of upper metallic members 410a and the protrusions of the plurality of lower metallic members 410b may be electrically connected to the source meter 160. If the protrusions of the plurality of upper metallic members 410a and the protrusions of the plurality of lower metallic members 410b are electrically connected to the source meter 160, accuracy in inspection of the insulation of the separator 10 may be further increased.

Each of the plurality of upper metallic members 410a may be coupled to an upper pressing frame 140a via a corresponding one of a plurality of upper resilient members 150a. The upper pressing frame 140a may be located above the plurality of upper metallic members 410a. The upper pressing frame 140a may press the plurality of upper metallic members 410a downwardly via the plurality of upper resilient members 150a. The resilient member 150 and the pressing frame 140 may be similar in structure and operation to the resilient member 150 and the pressing frame 140 of the insulation inspection apparatus 100 shown in FIGS. 1 and 2.

In the apparatus 400 for inspecting the insulation of the separator for secondary batteries, an upper insulating cover 430a may cover upper ends of the plurality of upper metallic members 410a, and a lower insulating cover 430b may cover lower ends of the plurality of lower metallic members 410b. The upper insulating cover 430a and the lower insulating cover 430b may be respectively similar to the upper insulating cover 330a and the lower insulating cover 330b of the insulation inspection apparatus 300 for inspecting the insulation of the separator for secondary batteries shown in FIGS. 5 and 6. However, the upper insulating cover 430a may also be located between the plurality of upper metallic members 410a, and the lower insulating cover 430b may also be located between the plurality of lower metallic members 410b.

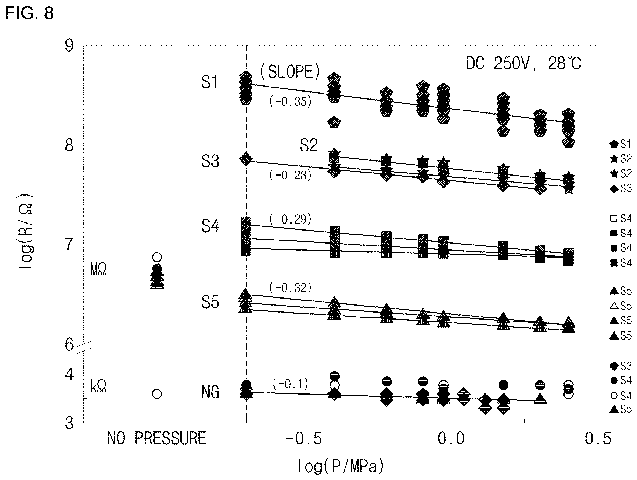

FIG. 8 is a view showing the results of inspection of the insulation of various separators inspected using the apparatus for inspecting the insulation of the separator for secondary batteries according to the present disclosure. The results of inspection of the insulation of various separators were acquired using the insulation inspection apparatus 300 for inspecting the insulation of the separator for secondary batteries shown in FIGS. 5 and 6. The x-axis direction, which is a row direction, indicates pressure applied to each separator through the apparatus for inspecting the insulation of the separator for secondary batteries, and the y-axis direction, which is a column direction, indicates the results of the insulation measured by the apparatus for inspecting the insulation of the separator for secondary batteries. Resistance values of megohms (MΩ) indicate that the insulation has been maintained, whereas resistance values of kilohms (kΩ) indicate that the insulation of the separators has been broken by pinholes (NG).

The plurality of separators may be separators having different thicknesses and made of different materials, and may include, for example, a first separator S1 to a fifth separator S5.

The first separator S1 may be a separator in which polypropylene (PP), polyethylene (PE), and polypropylene (PP) are laminated, wherein the thickness of polypropylene (PP) may be about 2 µm and the thickness of the polyethylene (PE) may be about 14 µm.

The second separator S2 may be made of polyethylene (PE) and may have a thickness of about 18 µm.

The third separator S3 may be a separator in which polypropylene (PP), polyethylene (PE), and polypropylene (PP) are laminated, wherein the thickness of polypropylene (PP) may be about 1 µm and the thickness of polyethylene (PE) may be about 14 µm.

The fourth separator S4 may be a separator in which ceramic, polyethylene (PE), and ceramic are laminated, wherein the thickness of ceramic may be about 1 µm and the thickness of polyethylene (PE) may be about 14 µm.

The fifth separator S5 may be a separator in which ceramic, polyethylene (PE), and ceramic are laminated, wherein the thickness of ceramic may be about 1 µm, and the thickness of polyethylene (PE) may be about 12 µm.

Among the plurality of separators, a separator (NG), of which the insulation has been broken by pinholes, may be included. Insulation of each of the first separator S1 to the fifth separator S5 was inspected. However, the thickness and material of the separator may be variously changed, and the insulation of each of the separators may be inspected through the apparatus for inspecting the insulation of the separator for secondary batteries according to the present disclosure even if the separators have various thicknesses and are made of different materials.

Each of the plurality of separators was inspected for insulation breakdown depending on the magnitude of pressure in a state of being interposed between the pair of metallic members 310 of the insulation inspection apparatus 300 for inspecting the insulation of the separator for secondary batteries. The insulation of each of the plurality of separators having different thicknesses and made of different materials was inspected using the insulation inspection apparatus 300 for inspecting the insulation of the separator for secondary batteries.

As can be seen from the insulation inspection results shown in FIG. 8, if no pressure is applied, the separator (NG) having insulation broken by pinholes, among the plurality of separators, may be measured as having similar resistance to the separators remaining insulated. If the insulation of the separator is measured through the source meter without pressure applied, the separator having broken insulation may be mismeasured as remaining insulated.

As can be seen from the insulation inspection results shown in FIG. 8, if a pressure of about 0.1 MPa or more is applied to the plurality of separators made of different materials and having different thicknesses, the insulation of the separator having broken insulation (NG) and the normal separators may be accurately measured. The apparatus for inspecting the insulation of the separator for secondary batteries according to the present disclosure may inspect the insulation of the separator in real time while applying a pressure of about 0.1 MPa or more, regardless of the thickness and material of the separator.

As can be seen from the insulation inspection results shown in FIG. 8, the apparatus for inspecting the insulation of the separator for secondary batteries according to the present disclosure may be capable of inspecting the insulation of each of separators made of various materials and having different thicknesses in real time while applying a pressure of about 0.1 MPa or more to the separator.

As is apparent from the above description, an apparatus for inspecting the insulation of a separator for secondary batteries according to one or more embodiments of the present disclosure may be capable of inspecting the insulation of a separator for secondary batteries in real time by applying current or voltage after pressing an upper metallic member and a lower metallic member toward each other.

The aspects of the present disclosure are not limited to those described above, and other unmentioned aspects will be apparent to those skilled in the art from the above description of exemplary embodiments.

The above is only one or more embodiments for implementing an apparatus for inspecting the insulation of a separator for secondary batteries according to the present disclosure, the present disclosure is not limited to the above embodiments, and a person having ordinary skill in the art to which the present disclosure pertains will recognize the technical of the present disclosure to the extent that various modifications can be made without departing from the gist of the present disclosure as claimed in the following claims, with functional equivalents thereof to be included therein.

## Claims

1. An apparatus (100) for inspecting insulation of a separator (10) for a battery, the apparatus (100) comprising:
an upper metallic member;
a lower metallic member under the upper metallic member, and configured to press the separator (10) with the upper metallic member; and
a source meter (160) electrically connected to the upper metallic member and to the lower metallic member, and configured to apply a voltage and/or current between the upper metallic member and the lower metallic member, and to measure resistance and/or current between the upper metallic member and the lower metallic member corresponding to the insulation of the separator (10).

2. The apparatus (100) as claimed in claim 1, wherein a shape of the upper metallic member and the lower metallic member is a column extending in a first direction.

3. The apparatus (100) as claimed in any one of claims 1 or 2, further comprising:
an fixed shaft (120a) extending through a central axis of the upper metallic member; and
a lower shaft (120b) extending through a central axis of the lower metallic member,
wherein the source meter (160) contacts, and is electrically connected to, the fixed shaft (120a) and the lower shaft (120b);
preferably wherein the upper metallic member is rotatable about the upper fixed shaft, wherein the lower metallic member is rotatable about the lower shaft (120b).

4. The apparatus (100) as claimed in any one of claims 1 to 3, further comprising:
an upper metal ball bearing (111a) between the fixed shaft (120a) and the upper metallic member; and
a lower metal ball bearing (111b) between the lower metallic member and the lower shaft (120b),
preferably wherein the upper metal ball bearing (111a) and the lower metal ball bearing (111b) comprise a conductor.

5. The apparatus (100) as claimed in any one of claims 1 to 4, wherein the upper metallic member is rotatable about the upper fixed shaft,
wherein the lower metallic member is rotatable about the lower shaft (120b), and
wherein the source meter (160) contacts, and is electrically connected to, the fixed shaft (120a) and the lower shaft (120b).

6. The apparatus (100) as claimed in any one of claims 1 to 5, further comprising:
an upper insulating cover (130a) covering an upper end of the upper metallic member, and spaced apart from the lower metallic member; and
a lower insulating cover (130b) covering a lower end of the lower metallic member, and spaced apart from the lower metallic member,
preferably wherein the upper insulating cover (130a) and the lower insulating cover (130b) are epoxidized and electrically connected to a ground wire of the source meter (160).

7. The apparatus (100) as claimed in any one of claims 1 to 6, further comprising:
an upper pressing frame (140a) configured to press the fixed shaft (120a) downwardly from above; and
a lower pressing frame (140b) configured to press the lower shaft (120b) upwardly from below.

8. The apparatus (100) as claimed in claim 7, further comprising:
an upper resilient member (150a) between the upper pressing frame (140a) and the upper fixed shaft; and
a lower resilient member (150b) between the lower pressing frame (140b) and the lower shaft (120b), preferably wherein the upper pressing frame (140a) and the lower pressing frame (140b) are configured to press the separator (10) between the upper metallic member and the lower metallic member.

9. The apparatus (100) as claimed in any one of claims 1 to 8, wherein the upper metallic member comprises a plurality of upper metallic members (110a) (110) spaced apart in a third direction substantially perpendicular to the first direction, and
wherein the lower metallic member comprises a plurality of lower metallic members (110a) under the upper metallic members (110a) to be spaced apart therefrom in an upward-downward direction that is substantially perpendicular to the first direction and to the third direction,
Preferably wherein each of the upper metallic member and the lower metallic member have a shape of a rectangular plate.

10. The apparatus (100) as claimed in any one of claims 1 to 9, further comprising:
an upper insulating cover (130a) covering an outside of the upper metallic member, and spaced apart from the upper metallic member; and
a lower insulating cover (130b) covering an outside of the lower metallic member, and spaced from the lower metallic member,
preferably wherein the upper insulating cover (130a) covers an upper surface and a side wall of the upper metallic member, and exposes a lower surface of the upper metallic member in a direction toward the lower metallic member, and
wherein the lower insulating cover (130b) covers a lower surface and a side wall of the lower metallic member, and exposes an upper surface of the lower metallic member in a direction toward the upper metallic member.

11. The apparatus (100) as claimed in claim 10, wherein a lower surface of the upper metallic member faces an upper surface of the lower metallic member.

12. The apparatus (100) as claimed in claim in any one of claims 1 to 11, wherein the upper metallic member further comprises an upper protrusion protruding and extending from opposite side walls thereof in the first direction, and
wherein the lower metallic member further comprises a lower protrusion protruding and extending from opposite side walls thereof in the first direction.

13. The apparatus (100) as claimed in any one of claims 1 to 12, wherein the source meter (160) contacts, and is electrically connected to, the upper protrusion and the lower protrusion.

14. The apparatus (100) as claimed in any one of claims 1 to 13, further comprising:
an upper pressing frame (140a) configured to press the upper protrusion downwardly from above;
a lower pressing frame (140b) configured to press the lower protrusion upwardly from below;
an upper resilient member (150a) between the upper pressing frame (140a) and the upper protrusion; and
a lower resilient member (150b) between the lower pressing frame (140b) and the lower protrusion.

15. The apparatus (100) as claimed in any one of claims 1 to 14, wherein the upper metallic member has a bar shape extending in the first direction, and comprises a plurality of upper metallic members (110a) spaced apart from each other in a third direction substantially perpendicular to the first direction, and
wherein the lower metallic member has a bar shape extending in the first direction, comprises a plurality of lower metallic members (110a) under the upper metallic members (110a) and spaced apart therefrom in an upward-downward direction that is substantially perpendicular to the first direction and to the third direction.
